(19) **Europäisches Patentamt**

**European Patent Office**

**Office européen des brevets**

(11) **EP 0 621 698 B1**

(12) **EUROPEAN PATENT SPECIFICATION**

(45) Date of publication and mention
of the grant of the patent:
**15.03.2000 Bulletin 2000/11**

(51) Int. Cl.[7]: **H03M 13/00**

(21) Application number: **94302805.0**

(22) Date of filing: **20.04.1994**

(54) **Error correction method including erasure correction, and apparatus therefore**

Fehlerbeseitigungsmethode mit inkludierter Löschungskorrektur und Vorrichtung hierfür

Méthode pour éliminer des fautes avec effacement des fautes et dispositif pour sa mise en oeuvre

(84) Designated Contracting States:
**DE FR GB IT NL**

(30) Priority: **21.04.1993 JP 9440893**

(43) Date of publication of application:
**26.10.1994 Bulletin 1994/43**

(73) Proprietor:
**CANON KABUSHIKI KAISHA**
**Tokyo (JP)**

(72) Inventors:
• **Iwamura, Keiichi**
**Shimomaruko, Ohta-ku, Tokyo (JP)**
• **Aizawa, Takayuki**
**Shimomaruko, Ohta-ku, Tokyo (JP)**
• **Narita, Izumi**
**Shimomaruko, Ohta-ku, Tokyo (JP)**
• **Suzuki, Takatoshi**
**Shimomaruko, Ohta-ku, Tokyo (JP)**

(74) Representative:
**Beresford, Keith Denis Lewis et al**
**BERESFORD & Co.**
**High Holborn**
**2-5 Warwick Court**
**London WC1R 5DJ (GB)**

(56) References cited:
**EP-A- 0 133 137       EP-A- 0 296 828**
**DE-A- 4 140 018       US-A- 4 633 470**
**US-A- 4 675 869       US-A- 4 845 713**
**US-A- 5 020 060       US-A- 5 107 504**
**US-A- 5 170 399**

**Description**

BACKGROUND OF THE INVENTION

Field of the Invention

The present invention relates to an error correction method for detecting and correcting data errors of data storage media such as optical disks, magnetooptical disks, and the like, data communication paths in satellite communications, and the like using error correction codes and, more particularly, to an error correction method using codes defined on a finite field such as Reed Solomon codes (to be referred to as RS codes hereinafter) and an apparatus therefor.

Related Background Art

In recent years, in order to improve reliability of various digital systems such as a memory system using a storage medium (e.g., an optical disk), an error correction method using error correction codes is popularly utilized. In particular, as such error correction codes, RS codes are widely used in optical disks, magnetooptical disks, satellite communications, and the like since they have an important feature for practical applications, i.e., they achieve the lowest redundancy among codes having the same code length and correction performance.

However, in a conventional method for processing encoding/decoding of RS codes at high speed, when erasure correction is not considered, and correction performance is as small as about 1 to 2, an apparatus can be relatively easily realized. However, when erasure is taken into consideration, processing is considerably complicated as compared to processing including no erasure correction even when the error correction performance is small.

US Patent 5,170,399 describes a method and apparatus for correction of errors and erasures using a Reed-Solomon decoder. The decoder uses a Euclid stack configured to function as a Euclid divide or a Euclid multiply module. In that way, the provision of separate Euclid divide and multiply stacks can be avoided. Therefore, when the decoder disclosed in the US patent is implemented by means of an integrated circuit, it can be produced on a smaller area than if it comprised separate Euclid divide and Euclid multiply stacks. In that way, the implementation of the decoder can be made using a die with reduced size, and so manufacturing yield from a particular wafer of semiconducting material can be increased.

SUMMARY OF THE INVENTION

It is, therefore, an objective of the present invention to provide a decoding method for performing error correction including erasure correction using a simple circuit arrangement, and an apparatus therefor.

It is another objective of the present invention to provide a decoding method for performing erasure correction at high speed by simple processing, and an apparatus therefor.

According to one aspect, the present invention which achieves these objectives relates to an error correction method comprising the steps of: generating a syndrome polynomial for a code to be corrected; generating an erasure position polynomial for the code to be corrected; calculating partial polynomials corresponding to portions, which have degrees smaller by at least 2 than a designed distance of the code, of a product of the generated syndrome polynomial and the generated erasure position polynomial; executing a multiplication for sequentially multiplying coefficients of the partial polynomials and the erasure position polynomials with a power of a primitive element of the code, power exponents being determined in units of coefficients; sequentially calculating sums of predetermined combinations of products every time the multiplication is executed; selecting a divisor and a dividend in accordance with the number of erasures included in the code on the basis of results of a plurality of predetermined arithmetic and logic operations which are sequentially executed using the sums; executing a division using the selected divisor and dividend; discriminating, based on the results of the predetermined arithmetic and logic operations which are sequentially executed using the sums, whether or not each of positions of the code is an error position; and correcting values of the code at the positions determined to be the error positions and at erasure positions on the basis of the result of the division.

According to another aspect, the present invention which achieves these objectives relates to an error correction apparatus comprising: first generation means for generating a syndrome polynomial for a code to be corrected; second generation means for generating an erasure position polynomial for the code to be corrected, in use; first arithmetic operation means for calculating partial polynomials corresponding to portions, which have degrees smaller by at least 2 than a desired distance of the code to he corrected, in use, of a product of the syndrome polynomial and the erasure position polynomial respectively generated by the first and second generation means; multiplication means for sequentially multiplying coefficients of the partial polynomials and the erasure position polynomials with a power of a primitive element of the code to be corrected, in use, power exponents being determined in units of coefficients; addition means for sequentially calculating sums of predetermined combinations of products every time the multiplication means executes the multiplication; second arithmetic operation means for sequentially executing a plurality of predetermined arithmetic and logic operations using the sums; selection means for selecting a divisor and a dividend in accordance with the number of erasures included in the code on the basis of a plurality of arithmetic operation results from the second arithmetic operation means; division means for executing a division using the divisor and dividend selected by the selection means; discrimination means for discriminating, based on the arithmetic operation results from the second arithmetic operation means, whether or not each of positions of the code is an error position; and correction means for correcting values of the code to be corrected, in use, at the positions determined to be the error positions and at erasure positions on the basis of the division result from the division means.

## BRIEF DESCRIPTION OF THE DRAWINGS

Fig. 1 is a flow chart showing the processing sequence of an error correction apparatus according to a specific embodiment of the present invention;
Fig. 2 is a block diagram showing the arrangement of an error correction apparatus of the specific embodiment;
Fig. 3 is a block diagram showing the detailed arrangement of a circuit for calculating the position and magnitude of an error in the specific embodiment; and
Fig. 4 is a block diagram showing the arrangement of an alternative error correction apparatus illustrated by way of example but not forming part of the present invention.

## DETAILED DESCRIPTION OF THE PREFERRED EMBODIMENTS

The preferred embodiments of the present invention will be described in detail hereinafter with reference to the accompanying drawings.

(Specific Embodiment)

For the sake of simplicity, a case of RS codes with a designed distance = "5" will be explained below. In RS codes, since a minimum distance d is equal to the designed distance, d = 5. In general, if the number of errors is represented by t, and the number of erasures is represented by s, $d \geq 2t + s + 1$ is satisfied. For this reason, when d = 5, a total of the numbers of correctable errors and erasures is at most 4, and correctable combinations are as follows. That is, when the number of erasures is 3 to 4, the number of errors is 0; when the number of erasures is 1 to 2, the number of errors is 1; and when the number of erasures is 0, the number of errors is 4. Thus, in the following description, the code length of RS codes is represented by n, and of 0th to (n-1)th positions in a code unit, the positions of errors or erasures are represented by h, i, j, and k. In correction, assume that the position of an erasure is obtained but its magnitude is unknown, and neither of the position and magnitude of an error are known. Also, the primitive root of the nth power of 1 is represented by $\alpha$.

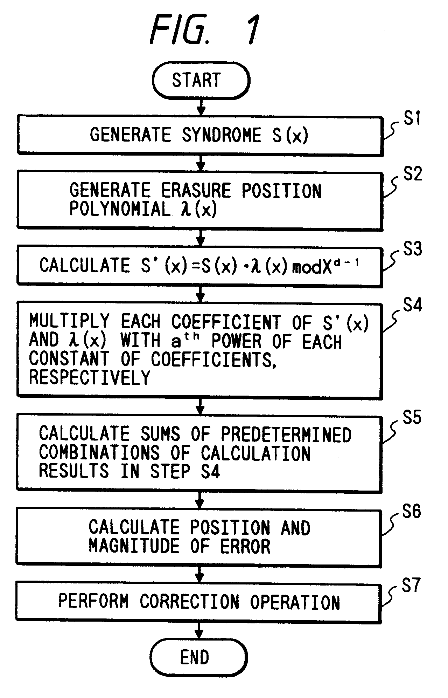

A decoding sequence of a received word as the principle of the present invention will be described below with reference to the flow chart in Fig. 1. In step S1, if a received word polynomial is represented by W(x), the following syndrome polynomial is generated based on $S_m = W(\alpha^m)$ :

$$S(x) = S_3 \cdot x^3 + S_2 \cdot x^2 + S_1 \cdot x + S_0$$

More specifically, we have:

$$S_0 = e_h + e_i + e_j + e_k$$

$$S_1 = \alpha^h \cdot e_h + \alpha^i \cdot e_i + \alpha^j \cdot e_j + \alpha^k \cdot e_k$$

$$S_2 = \alpha^{2h} \cdot e_h + \alpha^{2i} \cdot e_i + \alpha^{2j} \cdot e_j + \alpha^{2k} \cdot e_k$$

$$S_3 = \alpha^{3h} \cdot e_h + \alpha^{3i} \cdot e_i + \alpha^{3j} \cdot e_j + a^{3k} \cdot e_k$$

Then, in step S2, an erasure position polynomial $\lambda(x) = \lambda_3 \cdot x^3 + \lambda_2 \cdot x^2 + \lambda_1 \cdot x + \lambda_0$ is generated. More specifically, we have:

$$\lambda_4 = \alpha^{h+i+j+k}$$

$$\lambda_3 = \alpha^{h+i+j} + \alpha^{h+i+k} + \alpha^{h+j+k} + \alpha^{i+j+k}$$

$$\lambda_2 = \alpha^{h+i} + \alpha^{h+j} + \alpha^{h+k} + \alpha^{i+k} + \alpha^{j+k}$$

$$\lambda_1 = \alpha^h + \alpha^i + \alpha^j + \alpha^k$$

$$\lambda_0 = 1$$

In step S3, a product of the syndrome polynomial S(x) and the erasure position polynomial $\lambda(x)$, modulo $X^{d-1}$, is calculated as follows:

$$S'(x) = S(x) \cdot \lambda(x) \bmod X^{d-1}$$
$$= S'_3 \cdot x^3 + S'_2 \cdot x^2 + S'_1 \cdot x + S'_0$$

More specifically, we have:

$$S'_3 = S_3\lambda_0 + S_2\lambda_1 + S_1\lambda_2 + S_0\lambda_3$$

$$S'_2 = S_2\lambda_0 + S_1\lambda_1 + S_0\lambda_2$$

$$S'_1 = S_1\lambda_0 + S_0\lambda_1$$

$$S'_0 = S_0\lambda_0$$

Furthermore, in step S4, the coefficients, S'(x) and $\lambda(x)$, are multiplied with $\alpha^{-1}$, $\alpha^{-2}$, or $\alpha^{-3}$ $\underline{a}$ times ($0 \le a \le n-1$) as follows:

$$S_{x3} = S'_3 \cdot (\alpha^{-3})^a$$

$$S_{x2} = S'_2 \cdot (\alpha^{-2})^a$$

$$S_{x1} = S'_1 \cdot (\alpha^{-1})^a$$

$$\lambda_{x3} = \lambda_3 \cdot (\alpha^{-3})^a$$

$$\lambda_{x2} = \lambda_2 \cdot (\alpha^{-2})^a$$

$$\lambda_{x1} = \lambda_1 \cdot (\alpha^{-1})^a$$

In step S5, sums of the calculation results in step S4 for each $\underline{a}$ are calculated:

$$A_{x2} = S_{x3} + S_{x2}$$

$$A_{x1} = S_{x2} + S_{x1}$$

$$A_{x0} = S_{x1} + S_0$$

$$B_{x2} = \lambda_{x3} + \lambda_{x1}$$

$$B_{x1} = \lambda_{x2} + \lambda_{x1}$$

Using the above results, in step S6, the position and magnitude of an error are calculated by the following calculations:

When the number of erasures is 0,

double error position: position of $\underline{a}$ satisfying
$$L2 = A_{x0} \cdot A_{x2} + A_{x1}^2 = 0$$

4

single error position:    position of $\underline{a}$ satisfying
                          $L1 = A_{x2} = 0$
magnitude of error:       $EI = S_0 + A_{x0}^2/(A_{x0} + A_{x1})$

When the number of errors is 1 to 2,

error position:           position of $\underline{a}$ satisfying
                          $L1 = A_{x2} = 0$
magnitude of error:       $EI = S_{x2}/(B_{x1} + 1)$
magnitude of erasure:     $EJ = (A_{x2} \cdot A_{x0} + S_{x2}^2)/(A_{x2} \cdot \lambda_{x1})$

When the number of errors is 3 to 4,

magnitude of erasure:     $EJ = (A_{x2} + A_{x0})/B_{x2}$

Finally, in step S7, a correction operation is performed at the positions, which are determined to be error positions, on the basis of the error magnitudes.

Equations shown in step S6 will be proved below.

When the number of erasures is 3 to 4, the number of errors is 0, as described above, and all h, i, j, and k are erasures. At this time, since we have:

$$S_{x1} = S'_1 \cdot (\alpha^{-1})^a$$

$$= (S_1 \lambda_0 + S_0 \lambda_1) \cdot (\alpha^{-1})^a$$

$$= \{(\alpha^h \cdot e_h + \alpha^i \cdot e_i + \alpha^j \cdot e_j + \alpha^k \cdot e_k) \cdot 1$$
$$+ (e_h + e_i + e_j + e_k) \cdot (\alpha^h + \alpha^i + \alpha^j + \alpha^k)\}$$
$$\cdot (\alpha^{-1})^a$$

$$= \{(\alpha^i + \alpha^j + \alpha^k) \cdot e_h + (\alpha^h + \alpha^j + \alpha^k) \cdot e_i$$
$$+ (\alpha^h + \alpha^i + \alpha^k) \cdot e_j + (\alpha^h + \alpha^i + \alpha^j) \cdot e_k\}$$
$$\cdot (\alpha^{-1})^a$$

$$S_{x2} = S'_2 \cdot (\alpha^{-2})^a$$

$$= (S_2 \lambda_0 + S_1 \lambda_1 + S_0 \lambda_2) \cdot (\alpha^{-2})^a$$

$$= \{(\alpha^{2h} \cdot e_h + \alpha^{2i} \cdot e_i + \alpha^{2j} \cdot e_j + \alpha^{2k} \cdot e_k) \cdot 1$$
$$+ (\alpha^h \cdot e_h + \alpha^i \cdot e_i + \alpha^j \cdot e_j + \alpha^k \cdot e_k)$$
$$\cdot (\alpha^h + \alpha^i + \alpha^j + \alpha^k)$$
$$+ (e_h + e_i + e_j + e_k)$$
$$\cdot (\alpha^{h+i} + \alpha^{h+j} + \alpha^{h+k} + \alpha^{i+j} + \alpha^{i+k} + \alpha^{j+k})\}$$
$$\cdot (\alpha^{-2})^a$$

$$= \{(\alpha^{i+j} + \alpha^{i+k} + \alpha^{j+k}) \cdot e_h$$
$$+ (\alpha^{h+j} + \alpha^{h+k} + \alpha^{j+k}) \cdot e_i$$
$$+ (\alpha^{h+i} + \alpha^{h+k} + \alpha^{i+k}) \cdot e_j$$
$$+ (\alpha^{h+i} + \alpha^{h+j} + \alpha^{i+j}) \cdot e_k\} \cdot (\alpha^{-2})^a$$

$$S_{x3} = S'_3 \cdot (\alpha^{-3})^a$$

$$= (S_3 \lambda_0 + S_2 \lambda_1 + S_1 \lambda_2 + S_0 \lambda_3) \cdot (\alpha^{-3})^a$$

$$= \{(\alpha^{3h} \cdot e_h + \alpha^{3i} \cdot e_i + \alpha^{3j} \cdot e_j + \alpha^{3k} \cdot e_k) \cdot 1$$
$$+ (\alpha^{2h} \cdot e_h + \alpha^{2i} \cdot e_i + \alpha^{2j} \cdot e_j + \alpha^{2k} \cdot e_k)$$
$$\cdot (\alpha^h + \alpha^i + \alpha^j + \alpha^k)$$
$$+ (\alpha^h \cdot e_h + \alpha^i \cdot e_i + \alpha^j \cdot e_j + \alpha^k \cdot e_k)$$
$$\cdot (\alpha^{h+i} + \alpha^{h+j} + \alpha^{h+k} + \alpha^{i+j} + \alpha^{i+k} + \alpha^{j+k})$$
$$+ (e_h + e_i + e_j + e_k)$$
$$\cdot (\alpha^{h+i+j} + \alpha^{h+i+k} + \alpha^{h+j+k} \alpha^{i+j+k})\} \cdot (\alpha^{-3})^a$$

$$= (\alpha^{i+j+k} \cdot e_h + \alpha^{h+j+k} \cdot e_i + \alpha^{h+i+k} \cdot e_j + \alpha^{h+i+j} \cdot e_k)$$
$$\cdot (\alpha^{-3})^a$$

then, when, for example, a = h , we can prove:

$$(A_{x2} + A_{x0})/B_{x2} = (S_{x3} + S_{x2} + S_{x1} + S_0)/(\lambda_{x3} + \lambda_{x1})$$

$$= (\alpha^{i+j+k-3h} + \alpha^{i+j-2h} + \alpha^{i+k-2h} + \alpha^{j+k-2h} + \alpha^{i-h}$$

$$+ \alpha^{j-h} + \alpha^{k-h} + 1) \cdot e_h / \{(\alpha^{h+i+j} + \alpha^{h+i+k} + \alpha^{h+j+k} + \alpha^{i+j+k}) \cdot \alpha^{-3h} + (\alpha^h + \alpha^i + \alpha^j + \alpha^k) \cdot \alpha^{-h}\}$$

$$= e_h$$

The same applies to $a = i$, $j$, and $k$.

A case will be examined below wherein the number of erasures is 1 to 2. At this time, the number of errors is 1, as described above. Thus, $j$ and $k$ are assumed to be the erasure positions, and $i$ is assumed to be the error position. At this time, since we have:

$$S_{x1} = S'_1 \cdot (\alpha^{-1})^a$$

$$= (S_1 \lambda_0 + S_0 \lambda_1) \cdot (\alpha^{-1})^a$$

$$= \{(\alpha^i \cdot e_i + \alpha^j \cdot e_j + \alpha^k \cdot e_k) \cdot 1$$

$$+ (e_i + e_j + e_k) \cdot (\alpha^j + \alpha^k)\}$$

$$\cdot (\alpha^{-1})^a$$

$$= \{(\alpha^i + \alpha^j + \alpha^k) \cdot e_i + \alpha^k \cdot e_j + \alpha^j \cdot e_k\} \cdot (\alpha^{-1})^a$$

$$S_{x2} = S'_2 \cdot (\alpha^{-2})^a$$

$$= (S_2 \lambda_0 + S_1 \lambda_1 + S_0 \lambda_2) \cdot (\alpha^{-2})^a$$

$$= \{(\alpha^{2i} \cdot e_i + \alpha^{2j} \cdot e_j + \alpha^{2k} \cdot e_k) \cdot 1$$

$$+ (\alpha^i \cdot e_i + \alpha^j \cdot e_j + \alpha^k \cdot e_k) \cdot (\alpha^j + \alpha^k)$$

$$+ (e_i + e_j + e_k) \cdot \alpha^{j+k}\} \cdot (\alpha^{-2})^a$$

$$= (\alpha^{2i} + \alpha^{i+j} + \alpha^{i+k} + \alpha^{j+k}) \cdot e_i \cdot (\alpha^{-2})^a$$

$$S_{x3} = S'_3 \cdot (\alpha^{-3})^a$$

$$= (S_3 \lambda_0 + S_2 \lambda_1 + S_1 \lambda_2 + S_0 \lambda_3) \cdot (\alpha^{-3})^a$$

$$= \{(\alpha^{3i} \cdot e_i + \alpha^{3j} \cdot e_j + \alpha^{3k} \cdot e_k) \cdot 1$$

$$+ (\alpha^{2i} \cdot e_i + \alpha^{2j} \cdot e_j + \alpha^{2k} \cdot e_k) \cdot (\alpha^j + \alpha^k)$$

$$+ (\alpha^i \cdot e_i + \alpha^j \cdot e_j + \alpha^k \cdot e_k) \cdot \alpha^{j+k}\} \cdot (\alpha^{-3})^a$$

$$= (\alpha^{2i} + \alpha^{i+j} + \alpha^{i+k} + \alpha^{j+k}) \cdot e_i \cdot \alpha^i \cdot (\alpha^{-3})^a$$

then,

$$A_{x2} = S_{x3} + S_{x2}$$
$$= (\alpha^{2i} + \alpha^{i+j} + \alpha^{i+k} + \alpha^{j+k}) \cdot e_i \cdot (\alpha^{-3})^a \cdot (\alpha^i + \alpha^a)$$

Therefore, only when $a = i$, $A_{x2} = 0$. For this reason, by checking the value of $A_{x2}$, the error position can be detected.

When $a = i$, $S_{x2}/(B_{x1} + 1) = e_i$, and this calculation yields the magnitude of the error. Furthermore, when $a = j$, $(A_{x2} \cdot A_{x0} + S_{x2}{}^2)/(A_{x2} \cdot \lambda_{x1}) = e_j$, and similarly, when $a = k$, this results in $e_k$, thus obtaining erasure values.

Finally, when the number or erasures is 0, a correction technique for this case is known to those who are skilled in the art, and a detailed description thereof will be omitted. According to the present invention, when the number of erasures is 0, a conventional method is used, and when the number of erasures is 1 or more, the method of the present invention is used. Therefore, processing can be performed by a simple arrangement independently of the presence/absence of erasures.

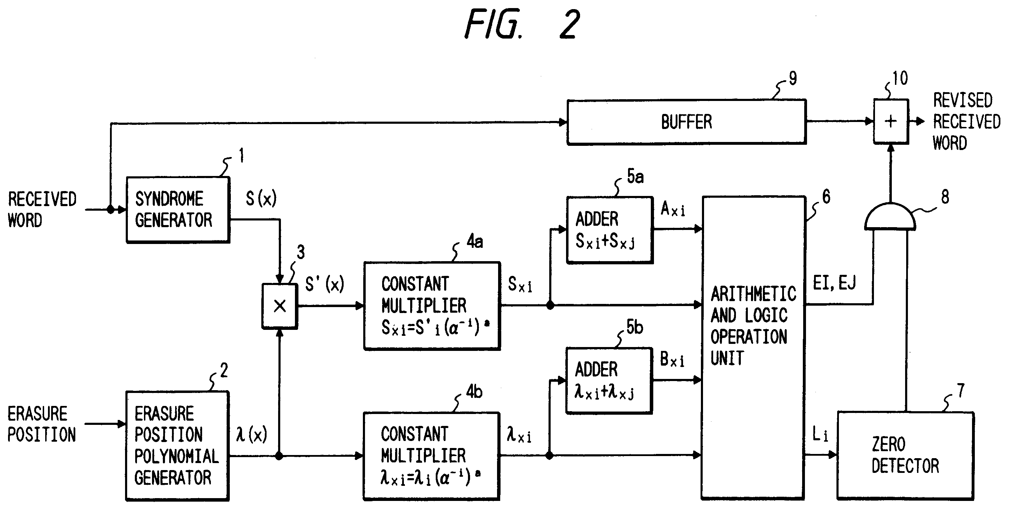

Fig. 2 shows the circuit arrangement based on the above-mentioned decoding sequence. Referring to Fig. 2, a syndrome generator 1 generates a syndrome polynomial $S(x)$ from a received word in step S1. An erasure position polynomial generator 2 generates an erasure position polynomial $\lambda(x)$ in step S2 on the basis of a given erasure position. A multiplier 3 performs multiplication in step S3 for calculating the product $S'(x) = S(x) \cdot \lambda(x) \bmod X^{d-1}$ of the syndrome polynomial $S(x)$ and the erasure position polynomial $\lambda(x)$, modulo $X^{d-1}$. A constant multiplier 4 executes processing in step S4 for multiplying a constant $\alpha^{-i}$ with the respective coefficients in the polynomial. An adder 5 adds the coefficients in the polynomial in step S5. An arithmetic and logic operation unit 6 executes an arithmetic operation in step S6 for calculating the position and magnitude of an error and the magnitude of an erasure.

In the correction operation, L1 or L2 = 0 for each position of codes sequentially output via a buffer 9 is detected by a zero detector 7 to discriminate an error position. When 0 is detected, EI is passed by an AND gate 8, and an adder 10 corrects the error. At the erasure position known in advance, the adder 10 corrects the erasure using EJ.

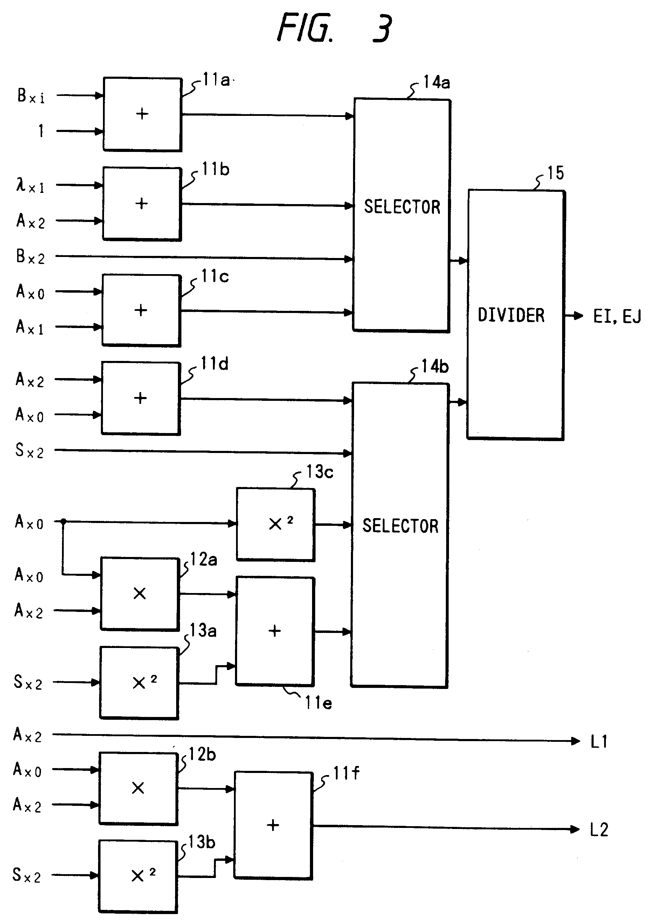

Fig. 3 is a circuit diagram showing the detailed arrangement of the arithmetic and logic operation circuit 6. Each of adders 11a to 11f adds two inputs, and outputs a sum. Each of multipliers 12a and 12b outputs a product of two inputs. Each of square circuits 13a to 13c outputs a square of an input. Each of selectors 14a and 14b selects one output from four inputs in accordance with the number and positions of erasures. A divider 15 executes division using the output from the selector 14a as a divisor and the output from the selector 14b as a dividend, and outputs the magnitude EI of an error or the magnitude EJ of an erasure. More specifically, when the number of erasures is 3 to 4, the selector 14a selects $B_{x2}$, and the selector 14b selects the output from the adder 11d. When the number of erasures is 1 to 2, at the positions of erasures, the selector 14a selects the output from the adder 11b and the selector 14b selects the output from the adder 11e, and at other positions, the selector 14a selects the output from the adder 11b and the selector 14b selects $S_{x2}$. When the number of erasures is 0, the selector 14a selects the output from the adder 11c, and the selector 14b selects the output from the square circuit 13c. The divider 15 obtains the reciprocal number of a divisor by reciprocal number conversion based on a table such as a ROM, and calculates a product of the obtained reciprocal number and a dividend. When the number of erasures is 0, EI is obtained by further adding $S_0$ to the output from the divider 15. In Fig. 3, inputs of the same values and same arithmetic operations are separately illustrated. However, on an actual circuit, these components may be connected to be able to commonly use the same values.

As described above, according to this embodiment, an error including an erasure can be corrected by a simple circuit arrangement.

(Alternative Arrangement)

As an alternative arrangement to the present invention, a circuit for correcting a single error irrespective of generation of an erasure will be described below.

For the sake of simplicity, as in the specific embodiment, a case of RS codes with a minimum distance d = 5 will be explained. A case will be examined below wherein the number of erasures is 1 to 2. At this time, the number of correctable errors is 1, as described above. Thus, j and k are assumed to be the erasure positions and i is assumed to be the error position. At this time, the syndrome polynomial $S(x)$ is given by:

$$S(x) = S_3 \cdot x^3 + S_2 \cdot x^2 + S_1 \cdot x + S_0$$

$$S_0 = e_i + e_j + e_k$$

$$S_1 = \alpha^i \cdot e_i + \alpha^j \cdot e_j + \alpha^k \cdot e_k$$

$$S_2 = \alpha^{2i} \cdot e_i + \alpha^{2j} \cdot e_j + \alpha^{2k} \cdot e_k$$

$$S_3 = \alpha^{3i} \cdot e_i + \alpha^{3j} \cdot e_j + \alpha^{3k} \cdot e_k$$

On the other hand, the erasure position polynomial $\lambda(x)$ is given by:

$$\lambda(x) = \lambda_2 \cdot x^2 + \lambda_1 \cdot x + \lambda_0$$
$$= \alpha^{j+k} \cdot x^2 + (\alpha^j + \alpha^k) \cdot x + 1$$

Therefore, when a product $S'(x) = 2(x) \cdot \lambda(x) \bmod X^{d-1} = S'_3 \cdot x^3 + S'_2 \cdot x^2 + S'_1 \cdot x + 2'_0$ of the syndrome polynomial $S(x)$ and the erasure position polynomial $\lambda(x)$, modulo $X^{d-1}$, is calculated, we have:

$$S'_3 = S_3\lambda_0 + S_2\lambda_1 + S_1\lambda_2 + S_0\lambda_3$$

$$S'_2 = S_2\lambda_0 + S_1\lambda_1 + S_0\lambda_2$$

$$S'_1 = S_1\lambda_0 + S_0\lambda_1$$

$$S'_0 = S_0\lambda_0$$

In particular,

$$S'_3 = e_i \cdot \alpha^{3i} \cdot \lambda(\alpha^{-i})$$

$$S'_2 = e_i \cdot \alpha^{2i} \cdot \lambda(\alpha^{-i})$$

Therefore, the position i and magnitude $e_i$ of an error can be respectively calculated by:

$$\alpha^{-i} = S'_2/S'_3$$

$$e_i = S'_3/(\lambda(\alpha^{-i}) \cdot \alpha^{3i})$$

When $\alpha^{-i}$ is expressed by x, $(\lambda(x) \cdot x^{-3})$ in an equation for calculating $e_i$ corresponds to a pattern obtained by altering the degree of the erasure position polynomial.

When $e_i$ is expressed as $e_i = S'_3\alpha^{-3i}/\lambda(\alpha^{-i})$, $e_i$ corresponds to a pattern obtained by multiplying $S'_3$ with a constant $\alpha^{-3i}$ and dividing the product with the erasure position polynomial $\lambda(\alpha^{-i})$.

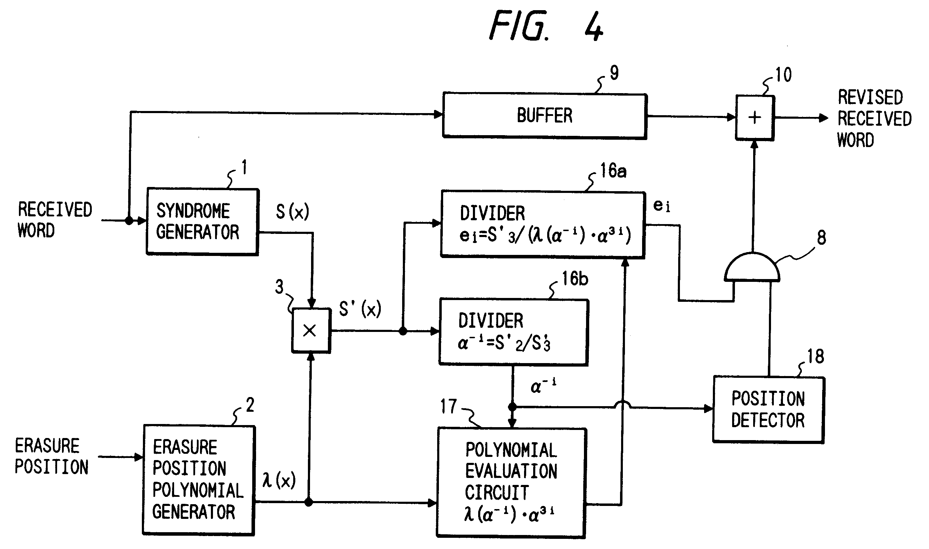

Therefore, arithmetic operations required for the above-mentioned method can be realized by an apparatus shown in Fig. 4. Referring to Fig. 4, a syndrome generator 1 generates a syndrome polynomial $S(x)$ from a received word. An erasure position polynomial generator 2 generates an erasure position polynomial $\lambda(x)$ on the basis of a given erasure position. A multiplier 3 calculates a product $S'(x) = S(x) \cdot \lambda(x) \bmod X^{d-1}$ of the syndrome polynomial $S(x)$ and the erasure position polynomial $\lambda(x)$, modulo $X^{d-1}$. The above-mentioned circuits are the same as those in the specific embodiment. Also, each of dividers 16a and 16b obtains the reciprocal number of a divisor by reciprocal number conversion based on a table such as a ROM, and calculates a product of the obtained reciprocal number and a dividend. A polynomial evaluation circuit 17 obtains a new polynomial $\lambda(x) \cdot x^{-3}$ by altering the degree of the erasure position polynomial $\lambda(x)$ generated by the erasure position polynomial generator 2, and then calculates a value obtained by substituting $\alpha^{-i}$ in the new polynomial. As can be understood from the fact that a polynomial $A(x)$ can be expressed by:

$$A(x) = a_n \cdot x^n + a_{n-1} \cdot x^{n-1} + \cdots + a_1 \cdot x + a_0$$
$$= ((\cdots (a_n \cdot x + a_{n-1}) \cdot x + a_{n-2}) \cdots) \cdot x + a_0$$

such a polynomial evaluation circuit can be realized by repeating a multiplication/addition in the form of $A \cdot X + B$. This multiplication/addition is realized by a repetitive arithmetic operation using a single circuit or parallel processing using a plurality of circuits. A position detector 18 opens an AND gate 8 at an error position i on the basis of $\alpha^{-i}$ output from the divider 16, and an adder 10 corrects a code output from a buffer 9 as in the specific embodiment of the invention.

As described above, according to this arrangement, a single error can be corrected by a simple circuit arrangement independently of generation of erasures.

**Claims**

1.    An error correction method comprising the steps of:

generating (S1) a syndrome polynomial for a code to be corrected;

generating (S2) an erasure position polynomial for the code to be corrected; and

calculating (S3) partial polynomials corresponding to portions, which have degrees smaller by at least 2 than a designed distance of the code, of a product of the generated syndrome polynomial and the generated erasure position polynomial;

characterised by the steps of:

executing (S4) a multiplication comprising sequentially multiplying coefficients of the partial polynomials and the erasure position polynomials with a power of a primitive element of the code, the power in each case corresponding with an ordinal of the coefficient;

sequentially calculating (S5) sums of predetermined combinations of products every time the multiplication is executed;

selecting a divisor and a dividend in accordance with the number of erasures included in the code on the basis of results of a plurality of predetermined arithmetic and logic operations which are sequentially executed using the sums;

executing a division using the selected divisor and dividend;

discriminating (S6), based on the results of the predetermined arithmetic and logic operations which are sequentially executed using the sums, whether or not each of positions of the code is an error position; and

correcting (S7) values of the code at the positions determined to be the error positions and at erasure positions on the basis of the result of the division.

2. A method according to claim 1, wherein, in the plurality of arithmetic and logic operations, different arithmetic operations are executed in parallel at each of the positions of the code in accordance with the numbers of correctable erasures and errors.

3. A method according to claim 1, wherein the discrimination and correction steps (S6, S7) are sequentially executed in correspondence with the positions of the code.

4. An error correction apparatus comprising:

first generation means (1) for generating a syndrome polynomial for a code to be corrected;

second generation means (2) for generating an erasure position polynomial for the code to be corrected, in use; and

first arithmetic operation means (3) for calculating partial polynomials corresponding to portions, which have degrees smaller by at least 2 than a designed distance of the code to be corrected, in use, of a product of the syndrome polynomial and the erasure position polynomial respectively generated by said first and second generation means (1, 2);

characterised by:

multiplication means (4a, 4b) for sequentially multiplying coefficients of the partial polynomials and the erasure position polynomials with a power of a primitive element of the code to be corrected, in use, power exponents being determined in units of coefficients;

addition means (5a, 5b) for sequentially calculating sums of predetermined combinations of products every time said multiplication means executes the multiplication;

second arithmetic operation means (6) for sequentially executing a plurality of predetermined arithmetic and logic operations using the sums;

selection means (14a, 14b) for selecting a divisor and a dividend in accordance with the number of erasures included in the code to be corrected, in use, on the basis of a plurality of arithmetic operation results from said second arithmetic operation means;

division means (15) for executing a division using the divisor and dividend selected by said selection means;

discrimination means (7, 8) for discriminating, based on the arithmetic operation results from said second arithmetic operation means, whether or not each of positions of the code to be corrected, in use, is an error position; and

correction means (10) for correcting values of the code to be corrected, in use, at the positions determined to be the error positions and at erasure positions on the basis of the division result from said division means (15).

5. An apparatus according to claim 4, wherein said second arithmetic operation means (6) parallelly executes different arithmetic operations at each of the positions of the code to be corrected, in use, in accordance with the numbers of correctable erasures and errors as the plurality of arithmetic and logic operations.

6. An apparatus according to claim 4 or claim 5, wherein the discrimination means (7, 8) and the correction means (10) are operable so as to perform respective discrimination and correction sequentially in accordance with said positions of the code to be corrected, in use.

**Patentansprüche**

1. Fehlerkorrekturverfahren mit den Schritten

    Erzeugen (S1) eines Syndrompolynoms für einen zu korrigierenden Code,
    Erzeugen (S2) eines Löschungspositionspolynoms für den zu korrigierenden Code und
    Berechnen (S3) von Teilpolynomen, die Abschnitten mit einem Grad entsprechen, der zumindest um 2 kleiner ist als eine bestimmte Codedistanz, aus einem Produkt aus dem erzeugten Syndrompolynom und dem erzeugten Löschungspositionspolynom,
    **gekennzeichnet durch** die Schritte
    Ausführen (S4) einer das aufeinanderfolgende Multiplizieren der Koeffizienten der Teilpolynome und der Löschungspositionspolynome mit einer Potenz eines Primitivelements des Codes aufweisenden Multiplikation, wobei die Potenz jeweils der Ordnungszahl des Koeffizienten entspricht,
    aufeinanderfolgendes Berechnen (S5) von Summen aus vorherbestimmten Kombinationen von Produkten bei jedem Ausführen der Multiplikation,
    Auswählen eines Divisors und Dividenden gemäß der im Code eingeschlossenen Anzahl von Löschungen auf der Grundlage von Ergebnissen einer Vielzahl vorherbestimmter arithmetischer und logischer Operationen, die unter Verwendung der Summen aufeinanderfolgend ausgeführt werden,
    Ausführen einer Division unter Verwendung des ausgewählten Divisors und Dividenden,
    Unterscheiden (S6), ob eine Position des Codes eine Fehlerposition ist oder nicht, auf der Grundlage der Ergebnisse der vorherbestimmten arithmetischen und logischen Operationen, die unter Verwendung der Summen aufeinanderfolgend ausgeführt werden, und
    Korrigieren (S7) der Werte des Codes an den als Fehlerpositionen ermittelten Positionen und an Löschungspositionen auf der Grundlage des Divisionsergebnisses.

2. Verfahren nach Anspruch 1, wobei bei der Vielzahl arithmetischer und logischer Operationen in Übereinstimmung mit der Anzahl korrigierbarer Löschungen und Fehler verschiedene arithmetische Operationen an jeder Position des Codes parallel ausgeführt werden.

3. Verfahren nach Anspruch 1, wobei die Schritte der Unterscheidung und Korrektur (S6, S7) in Übereinstimmung mit den Positionen des Codes aufeinanderfolgend ausgeführt werden.

4. Fehlerkorrekturvorrichtung mit

    einer ersten Erzeugungseinrichtung (1), die ein Syndrompolynom für einen zu korrigierenden Code erzeugt,
    einer zweiten Erzeugungseinrichtung (2), die bei Verwendung ein Löschungspositionspolynom für den zu korrigierenden Code erzeugt, und
    einer ersten arithmetischen Operationseinrichtung (3), die bei Verwendung Teilpolynome, die Abschnitten mit einem Grad entsprechen, der zumindest um 2 kleiner ist als eine bestimmte Codedistanz des zu korrigierenden Codes, aus einem Produkt aus dem Syndrompolynom und dem Löschungspositionspolynom, die jeweils von der ersten und zweiten Erzeugungseinrichtung (1, 2) erzeugt worden sind, berechnet,
    **gekennzeichnet durch**
    eine Multiplikationseinrichtung (4a, 4b), die bei Verwendung aufeinanderfolgend die Koeffizienten der Teilpolynome und der Löschungspositionspolynome mit einer Potenz eines Primitivelements des zu korrigierenden Codes multipliziert, wobei die Exponenten der Potenz in Einheiten der Koeffizienten bestimmt werden,
    eine Additionseinrichtung (5a, 5b), die bei jedem Ausführen der Multiplikation durch die Multiplikationseinrichtung aufeinanderfolgend Summen aus vorherbestimmten Kombinationen von Produkten berechnet,
    eine zweite arithmetische Operationseinrichtung (6), die aufeinanderfolgend eine Vielzahl vorherbestimmter arithmetischer und logischer Operationen unter Verwendung der Summen ausführt,
    eine Auswahleinrichtung (14a, 14b), die bei Verwendung einen Divisor und Dividenden gemäß der Anzahl der im zu korrigierenden Code eingeschlossenen Löschungen auf der Grundlage einer Vielzahl von Ergebnissen arithmetischer Operationen von der zweiten arithmetischen Operationseinrichtung auswählt,
    eine Divisionseinrichtung (15), die eine Division unter Verwendung des von der Auswahleinrichtung ausgewählten Divisors und Dividenden ausführt,
    eine Unterscheidungseinrichtung (7, 8), die bei Verwendung basierend auf den Ergebnissen der arithmetischen Operationen von der zweiten arithmetischen Operationseinrichtung unterscheidet, ob eine Position des zu korrigierenden Codes eine Fehlerposition ist oder nicht, und

eine Korrektureinrichtung (10), die bei Verwendung Werte des zu korrigierenden Codes an den als Fehlerpositionen ermittelten Positionen und an Löschungspositionen auf der Grundlage des Divisionsergehnisses der Divisionseinrichtung (15) korrigiert.

5. Vorrichtung nach Anspruch 4, wobei die zweite arithmetische Operationseinrichtung (6) bei Verwendung an jeder Position des zu korrigierenden Codes verschiedene arithmetische Operationen gemäß der Anzahl der korrigierbaren Löschungen und Fehler als Vielzahl der arithmetischen und logischen Operationen parallel ausführt.

6. Vorrichtung nach Anspruch 4 oder 5, wobei die Unterscheidungseinrichtung (7, 8) und die Korrektureinrichtung (10) bei Verwendung betreibbar sind, um die jeweilige Unterscheidung und Korrektur gemäß den Positionen des zu korrigierenden Codes aufeinanderfolgend durchzuführen.

**Revendications**

1. Procédé de correction d'erreurs comprenant les étapes :

   de production (S1) d'un polynôme de syndrome pour un code à corriger ;
   de production (S2) d'un polynôme de position d'effacement pour le code à corriger ; et
   de calcul (S3) de polynômes partiels correspondant à des parties, qui ont des degrés plus petits d'au moins 2 qu'une distance désignée du code, d'un produit du polynôme de syndrome engendré et du polynôme de position d'effacement engendré ;
   caractérisé par les étapes :
   d'exécution (S4) d'une multiplication comprenant des coefficients de multiplication séquentielle des polynômes partiels et des polynômes de position d'effacement avec une puissance d'un élément primitif du code, la puissance correspondant dans chaque cas à un nombre ordinal du coefficient ;
   de calcul séquentiel (S5) de sommes de combinaisons prédéterminées de produits chaque fois que la multiplication est exécutée ;
   de choix d'un diviseur et d'un dividende en fonction du nombre d'effacements inclus dans le code sur la base de résultats d'une pluralité d'opérations arithmétiques et logiques prédéterminées qui sont exécutées séquentiellement en utilisant les sommes ;
   d'exécution d'une division en utilisant le diviseur et le dividende choisis ;
   de discrimination (S6), en se basant sur les résultats des opérations arithmétiques et logiques prédéterminées qui sont exécutées séquentiellement en utilisant les sommes, du fait que chacune des positions du code est, ou non, une position d'erreur ; et
   de correction (S7) de valeurs du code, aux positions déterminées pour être les positions d'erreur et aux positions d'effacement, sur la base du résultat de la division.

2. Procédé selon la revendication 1, dans lequel, dans la pluralité d'opérations arithmétiques et logiques, on exécute des opérations arithmétiques différentes en parallèle, à chacune des positions du code, en fonction des nombres d'effacements et d'erreurs corrigibles.

3. Procédé selon la revendication 1, dans lequel les étapes (S6, S7) de discrimination et de correction sont exécutées séquentiellement en correspondance avec les positions du code.

4. Dispositif de correction d'erreurs comprenant :

   un premier moyen générateur (1) destiné à engendrer un polynôme de syndrome pour un code à corriger ;
   un second moyen générateur (2) destiné, en utilisation, à engendrer un polynôme de position d'effacement pour le code à corriger ; et
   un premier moyen (3) d'opération arithmétique destiné, en utilisation, à calculer des polynômes partiels correspondant à des parties, qui ont des degrés plus petits d'au moins 2 qu'une distance désignée du code à corriger, d'un produit du polynôme de syndrome et du polynôme de position d'effacement, engendrés, respectivement, par lesdits premier et second moyens générateurs (1, 2) ;
   caractérisé par :
   un moyen (4a, 4b) de multiplication destiné, en utilisation, à multiplier séquentiellement des coefficients des polynômes partiels et des polynômes de position d'effacement avec une puissance d'un élément primitif du code à corriger, les exposants de puissance étant déterminés coefficient par coefficient ;

un moyen (5a, 5b) d'addition destiné à calculer séquentiellement des sommes de combinaisons prédéterminées de produits, chaque fois que ledit moyen de multiplication exécute la multiplication ;

un second moyen (6) d'opération arithmétique destiné à exécuter séquentiellement une pluralité d'opérations arithmétiques et logiques prédéterminées en utilisant les sommes ;

un moyen (14a, 14b) de choix destiné, en utilisation, à choisir un diviseur et un dividende en fonction du nombre d'effacements inclus dans le code à corriger, sur la base d'une pluralité de résultats d'opération arithmétique provenant dudit second moyen d'opération arithmétique ;

un moyen (15) de division destiné à exécuter une division en utilisant le diviseur et le dividende choisis par ledit moyen de choix ;

un moyen (7, 8) de discrimination destiné, en utilisation, à discriminer, en se basant sur les résultats d'opération arithmétique provenant dudit second moyen d'opération arithmétique, si chacune des positions du code à corriger est, ou non, une position d'erreur ; et

un moyen (10) de correction destiné, en utilisation, à corriger des valeurs du code à corriger, aux positions déterminées comme étant les positions d'erreur et aux positions d'effacement, sur la base du résultat de division provenant dudit moyen (15) de division.

5. Dispositif selon la revendication 4, dans lequel, en utilisation, ledit second moyen (6) d'opération arithmétique exécute parallèlement, en tant que la pluralité d'opérations arithmétiques et logiques, des opérations arithmétiques différentes à chacune des positions du code à corriger, en fonction des nombres d'effacements et d'erreurs corrigibles.

6. Dispositif selon la revendication 4 ou la revendication 5, dans lequel, en utilisation, le moyen (7, 8) de discrimination et le moyen (10) de correction peuvent être mis en oeuvre de façon à effectuer séquentiellement la discrimination et la correction, respectives, en fonction desdites positions du code à corriger.

## FIG. 1

```
        ( START )

  ┌─────────────────────────────┐  ┌ S1
  │   GENERATE SYNDROME S(x)     │
  └─────────────────────────────┘
              │
              ▼
  ┌─────────────────────────────┐  ┌ S2
  │   GENERATE ERASURE POSITION  │
  │   POLYNOMIAL λ(x)            │
  └─────────────────────────────┘
              │
              ▼
  ┌─────────────────────────────┐  ┌ S3
  │ CALCULATE S'(x)=S(x)·λ(x)modX^(d-1) │
  └─────────────────────────────┘
              │
              ▼
  ┌─────────────────────────────┐  ┌ S4
  │ MULTIPLY EACH COEFFICIENT    │
  │ OF S'(x) AND λ(x) WITH a^th  │
  │ POWER OF EACH CONSTANT OF    │
  │ COEFFICIENTS, RESPECTIVELY   │
  └─────────────────────────────┘
              │
              ▼
  ┌─────────────────────────────┐  ┌ S5
  │ CALCULATE SUMS OF            │
  │ PREDETERMINED COMBINATIONS   │
  │ OF CALCULATION RESULTS IN    │
  │ STEP S4                      │
  └─────────────────────────────┘
              │
              ▼
  ┌─────────────────────────────┐  ┌ S6
  │ CALCULATE POSITION AND       │
  │ MAGNITUDE OF ERROR           │
  └─────────────────────────────┘
              │
              ▼
  ┌─────────────────────────────┐  ┌ S7
  │ PERFORM CORRECTION OPERATION │
  └─────────────────────────────┘
              │
              ▼
          ( END )
```

FIG. 2

## FIG. 3

## FIG. 4